# EUROPEAN PATENT SPECIFICATION

(11) **EP 0 734 546 B1**
(45) Date of publication and mention of the grant of the patent: **17.10.2001**
(21) Application number: 95905933.8
(22) Date of filing: 13.12.1994
(51) Int. Cl.: G05B 9/02, G11C 5/14

(54) **DATA PROCESSING MEDIUM, ITS BACKUP CIRCUIT, AND DATA PROCESSING SYSTEM**
DATENVERARBEITUNGSMEDIUM, DATENSICHERUNGSSCHALTUNG DAFÜR UND DATENVERARBEITUNGSSYSTEM
MOYEN DE TRAITEMENT DE DONNEES, SON CIRCUIT DE SAUVEGARDE ET SON SYSTEME DE TRAITEMENT DES DONNEES

(30) Priority: 17.12.1993 JP 31805393
(43) Date of publication of application: 02.10.1996
(73) Proprietor: BERG ELECTRONICS MANUFACTURING B.V., 5222 AV's-Hertogenbosch (NL)
(72) Inventor: AMANO, Kazutoshi, Tokyo 158 (JP)
(74) Representative: Barnard, Eric Edward
(86) International application number: US9414364
(87) International publication number: WO9516940

(56) References cited:
- EP-A- 0 437 129
- DE-A- 4 026 798
- US-A- 3 816 768
- US-A- 3 982 141
- US-A- 4 492 876
- US-A- 4 677 311
- US-A- 5 033 882

## Description

### Field of the Invention

This invention relates generally to a data processing medium. More particularly, this invention relates to a circuit for backing up stored data in a semiconductor element of a data processing medium and to a data processing medium with the backup circuit. Additionally, this invention relates to a data processing system containing the data processing medium and a data processing unit.

### BACKGROUND OF THE INVENTION

In general, a data processing medium such as a memory card is supplied with a driving voltage from a data processing unit (typically, a personal computer and its peripheral equipment) in which the medium is to be installed. When the supply of the voltage to a memory card using a static random access memory (hereinafter, abbreviated as an S-RAM) as the data storage element is cut off, the stored data will be lost.

Accordingly, to back up the stored data in the S-RAM of a memory card, various backup circuits and circuit systems have been proposed.

As one known example, there is a circuit in which the voltage supply line of a memory card is connected to a parallel combination of the main battery acting as a first backup means, an auxiliary battery acting as a second backup means (a large capacitor), and an S-RAM. In this circuit, while the memory card is being removed from the data processing unit, the main battery supplies a voltage to the S-RAM to retain the stored data in the S-RAM. When the main battery is replaced, the large capacitor supplies a voltage for retaining the stored data in the S-RAM.

Generally, when data is read from the S-RAM, a higher voltage than that of the main battery is supplied from an external power supply (a power supply build in the data processing unit) to the S-RAM through the voltage supply line. In the case of a circuit using a conventional large capacitor, the voltage from the external power supply is also supplied to the large capacitor. This permits a charging current to flow into the large capacitor at the same time that an operating current flows into the S-RAM.

The charging current to the large capacitor is a wasteful load to the external power supply. The large capacitor is required to have a high withstand voltage so as to withstand the voltage from the external power-supply line. Therefore, it is necessary to use a relatively expensive large capacitor for the conventional circuit.

As another known example, there is a circuit system in which the current line of the power supply for an IC card is connected to a parallel combination of the main battery acting as a first backup means, a rechargeable auxiliary battery (a lithium battery) acting as a second backup means, and an S-RAM, with a diode and a constant-voltage circuit connected between the power supply and the lithium battery. In this circuit system, the lithium battery backs up the S-RAM when the main battery is replaced.

In the conventional circuit system, however, the lithium battery is charged only when a high voltage for operating the S-RAM, for example, a +5 voltage is applied from the power supply. Therefore, before the replacement of the main battery, the lithium battery must be charged from the power supply. Furthermore, because the conventional circuit system contains a constant-voltage source, its design and arrangement are complex.

Additionally, in the conventional circuit or circuit system, each time that the power supply applies a voltage to the S-RAM, the auxiliary battery (the large capacitor or lithium battery) is also charged. However, since the number of charges and discharges is limited for the large capacitor or lithium battery, frequent charging and discharging degrades its characteristics.

Other known back-up circuits are described in EP-A-0437129, US-A-3982141 and DE-A-4026798.

### SUMMARY OF THE INVENTION

A general object of the present invention is to solve problems peculiar to the above-described conventional circuit and circuit system. Specifically, the object of the invention is to provide a data processing medium, its backup circuit, and a data processing system which prevent a charging current from flowing from an external power supply into a second backup means, allow use of a second backup means with low withstand voltage characteristics, require no charging of the second backup means before the replacement of a first backup means, and are able to reduce the number of charges and discharges of the second backup means.

According to the invention there is provided a backup circuit for backing up stored data in a data processing medium comprising a semiconductor element which can at least store data and a voltage input terminal which can be connected to an external power supply and a voltage supply line connected to the input terminal to supply a voltage from the external power supply so as to operate the semiconductor element, said backup circuit comprising:
first and second backup means each of which serves to backup the stored data in the semiconductor element during the time when the external power supply is disconnected from the voltage input terminal, each backup means having a positive and a negative electrode
wherein: charging prevention means is connected to the positive electrodes of both the first and second backup means and to the voltage supply line so as to prevent charging of both the backup means when the voltage input terminal is connected to the external power supply;
the first backup means is re-chargeable and removable and the positive electrodes of the first and second backup means are directly interconnected electrically so the second backup means is charged only by the first backup means;
the positive electrode of the second backup means is electrically connected to the semiconductor element via the charging preventing means and the voltage supply line so as to energize the semiconductor element and back up the stored data in the semiconductor element during the time when the external power supply is disconnected from the voltage input terminal and the first backup means is removed from the data processing medium, and
the positive electrode of the first backup means is electrically connected to the semiconductor element via the charging preventing means and the voltage supply line to energize the semiconductor element and back up the stored data in the semiconductor element when the external power supply is disconnected from the voltage input terminal.

The invention also provides a data processing medium incorporating a semiconductor element which can at least store data, a voltage input terminal connectable to an external power supply, a voltage supply line connected to the terminal to supply a voltage from the external supply to operate the semiconductor element and a backup circuit as defined above.

The data processing medium may be an integrated circuit card or a memory card while the semiconductor element may be a static random access memory.

The second backup means may be a capacitor or a rechargeable battery.

In a preferred embodiment the charging preventing means is a diode arranged in a forward conductive direction runing from the positive electrode of the first backup means toward said supply line and the first and second backup means have their positive electrodes connected in parallel via a resistance.

A further diode can be connected between the supply line and the terminal to prevent the flow of electrical current from the first and second backup means to the external power supply when the power supply is connected to the terminal. Because the positive electrodes of the first and second backup means are connected in parallel, the second backup means is constantly charged from the first backup means. Because the charging prevention means is provided between the positive electrodes of the first backup means and the second backup means and the external power supply, the second backup means is not charged from the external power supply.

According to another aspect of the invention, there is provided a data processing system comprising a data processing medium as defined above and a data processing unit to which the data processing medium is to be connected, said data processing unit comprising said power supply for supplying voltage to the terminal and transmission/reception means for transmitting and/or receiving data to and from said semiconductor element of said data processing medium.

### BRIEF DESCRIPTION OF THE DRAWINGS

Figure 1 is a circuit block diagram of a data processing system according to a first embodiment of the present invention
Figure 2 is a circuit block diagram of a second embodiment of the invention

### DETAILED DESCRIPTION OF THE PREFERRED EMBODIMENTS

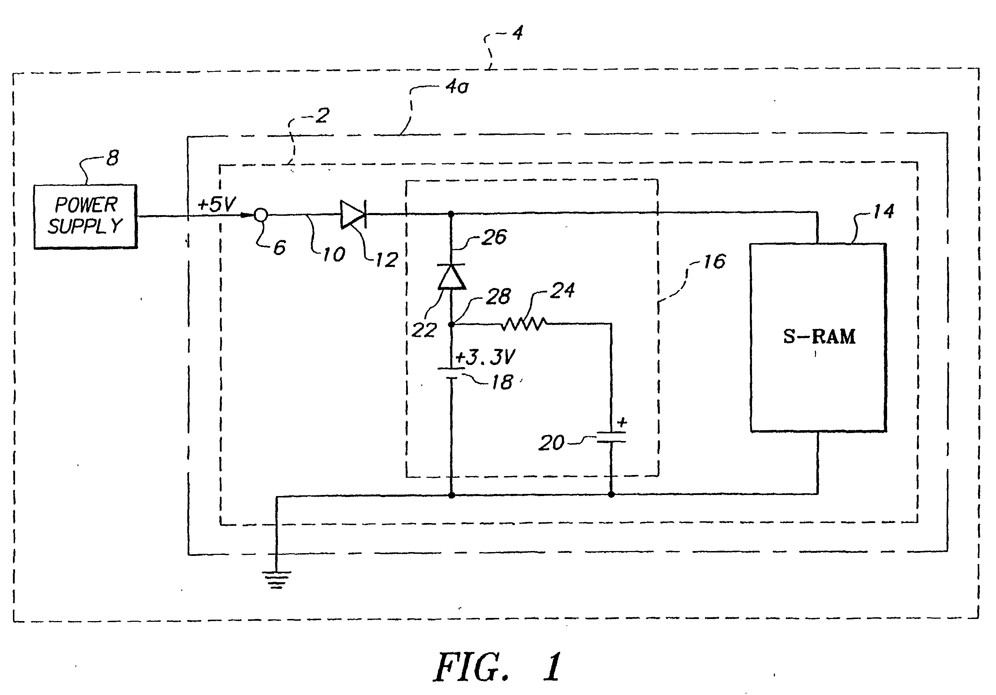

With reference to FIG. 1, in a data processing system of the present invention, data processing medium generally indicated by reference symbol 2 is a memory card to be installed in a data processing unit (e.g., a personal computer and its peripheral equipment) 4 for transmitting and receiving to and from the medium.

The memory card 2 is installed detachably in the data processing unit 4 via, for example, a connector 4a provided in the data processing unit 4. The connector 4a is electrically connected to a data transmission/reception system (not shown) of the data processing unit 4. It is desirable that the connector 4a should be a detachable type to the data processing unit 4. For example, the connector disclosed in Japanese Utility Model Application No. 2-90772 (the corresponding U.S. Pat. No. 5,152,697) can be used.

This invention relates chiefly to backing up the stored data in the memory card 2, so that a detailed explanation of the data transmission and reception system between the memory card 2 and the data processing unit 4 and of the connector 4a will be omitted. In FIG. 1, the dimensions of the memory card 2 are drawn exaggeratedly with respect to the general data processing unit 4.

FIG. 1 shows a state where the memory card 2 is installed properly in the data processing unit 4 via the connector 4a. In this state, the voltage input terminal 6 of the memory card 2 can be connected to an external power supply (a power supply built in the data processing unit 4) via the connector 4a. The external power supply 8 typically supplies a +5-V voltage to the input terminal 6 of the memory card 2. The voltage supply line 10 extended from the input terminal 6 of the memory card 2 is provided with a first diode 12 for preventing the battery current from flowing backward to the external power supply 8. The purpose of placing the diode 12 is to prevent the battery (explained later) in the card 2 from being consumed faster due to the backward flow of current from the battery (explained later0 in the card 2 to the unit 4, because the voltage of the external power supply 8 drops to zero when the driving power supply of the data processing unit 4 is turned off while the memory card 2 remains in contact with the data processing unit 4.

The voltage supply line 10 in the downstream of the first diode 12 is connected to a parallel combination of a semiconductor element 14 and its backup circuit 16.

The semiconductor element 14 in the embodiment is a static random access memory (hereinafter, referred to as an S-RAM). The power consumption of the S-RAM 14 is 5 v at the time of reading and writing. When the voltage input terminal 6 of the memory card 2 is not connected to the external power supply 8, that is, when the memory card 2 is not connected to the data processing unit 4, the power consumption of the S-RAM 14 is required to be 2 V or more in order to back up the stored data. The ordinary S-RAM 14 can be backed up at voltages ranging from 2 V to 5.5 V.

The backup circuit 16 contains a main battery 18, an auxiliary battery 20, and a second diode 22.

The main battery 18 is a commercially available coin-type lithium battery of the CR2025 type, whose nominal output voltage is 3 V (actually, 3.3 V). For the auxiliary battery 20, a rechargeable battery or a capacitor may be used. In the present embodiment, a 0.1-F polyacelene capacitor is used.

The positive electrode of the main battery 18 and that of the auxiliary battery 20 are connected in parallel directly or via a resistor 24. When the resistor 24 is used, the resistance is preferably 1 kΩ or less. The reason for this will be explained later.

The second diode 22 is provided in a line 26 running from the voltage supply line 10 to the junction 28 of the main battery 18 and the auxiliary battery 20. Since the second diode 22 is placed in a forward direction running from the junction 28 toward the voltage supply line 10, the auxiliary battery 20 is charged only from the main battery 18, thereby preventing a charging current from flowing into the auxiliary battery 20 from the external battery 8.

Therefore, the withstand voltage of the auxiliary battery 20 has only to be nearly the maximum output voltage (in the embodiment, 3.3 V) of the main battery 18. It is not necessary to take into account the withstand voltage of the auxiliary battery 20 with respect to the output voltage (in the embodiment, 5V) of the external battery 8. The second diode 22 is placed to prevent the main battery 18 from being charged. In the present embodiment, placing the diode 22 enables the number of charges and discharges of the auxiliary battery 20 to be reduced, thereby extending the service life of the auxiliary battery 20 and also enabling use of a low withstand voltage auxiliary battery 20.

The negative electrodes of the semiconductor element 14, main battery 18, and auxiliary battery 20 are each connected to a ground line 30.

The reason why it is desirable that the resistance of the resistor 24 should be 1 kΩ or less will be described below.

The resistance of the resistor 24 is 1 KΩ. With the auxiliary battery 20 fully discharged (consequently the output voltage is 0 V), when a new main battery 18 whose output voltage is 3.3 V is installed, a maximum current of 3.3 mA (= 3.3 V/1 KΩ) will flow in the transition period at the beginning of charging. A current on this order is not a heavy load to the new main battery 18. At this time, a drop in the output voltage of the main battery 18 is approximately 0.2 v. The drop in the output voltage was measured with a 1-KΩ constant resistance load being connected to a coin-type lithium battery of the CR2025 type.

As the auxiliary 20 is charged more, the charging current reduces accordingly, with the result that the output voltage of the main battery 18 rises and restores the original condition. Therefore, even if the resistance is reduced, only a momentary voltage drop will take place. Because the output voltage of the main battery 18 restores the original condition as the charging of the auxiliary battery 20 makes progress, there arises no serious function problem.

The commercially available coin-type lithium battery of the CR2025 type has a maximum discharging current of approximately 6 mA continuous and 50 mA in pulse form. When the lowest resistance of the resistor 24 is obtained from the current (50 mA) of the pulse load, it will give 600 Ω (= 3 V/50 mA).

Because it is hard for current to flow into the auxiliary battery 20 when the resistance of the resistor 24 is too large, it takes time to charge the auxiliary battery 20. In replacing the main battery 18, because the backup current is also supplied to the S-RAM 14 via the resistor when the S-RAM 14 is backed up only by the auxiliary battery 20, the backup voltage of the S-RAM 14 will drop. For example, with the resistance of the resistor 24 being 10 KΩ , when a 10-*µ* A backup current flows, a 0.1-V voltage drop will take place due to the resistor 24. Since the output voltage of the main battery 18 is naturally low at the time of replacement of the main battery 18, the potential of the auxiliary battery 20 connected in parallel to the main battery 18 is also at the same level. Therefore, it is desirable that the output voltage of the auxiliary battery 20 should be used effectively at the time of' replacement of the main battery 18 by minimizing a voltage drop due to the resistor 24. Accordingly, the lower the resistance of the resistor 24, the better. If the resistance of the resistor 24 is 1 KΩ , a voltage drop due to a backup current of 10 *µ* A is 10 mV, which is almost negligible.

Another purpose of placing the resistor 24 is to protect the main battery 18 if the auxiliary battery 20 should break down and be short-circuited. If the resistor 24 is not provided, an excessive current will flow from the main battery 18 in case the auxiliary battery 20 breaks down and goes short-circuited, permitting the main battery 18 to generate heat. In the worst case, the main battery 18 can explode. By placing the resistor 24, however, current in the main battery 18 can be limited to prevent the main battery 18 from generating heat and exploding.

The procedure for replacing the main battery 18 of the memory card 2 and the operation of the backup circuit will be described as follows.
(i) First, the memory card 2 is removed from the data processing unit 4. This disconnects the built-in power supply 8 of the data processing unit 4 from the memory card 2. In this case, because the main battery 18 supplies a 3-V voltage to the S-RAM 14, the stored data in the S-RAM 14 is retained.
(ii) Then, to replace the main battery 18, the main battery 18 is removed from the memory card 2. In this case, because the auxiliary battery 20 supplies a voltage to the S-RAM 14, the stored data in the S-RAM 14 is retained. Since the main battery 18 charges the auxiliary battery 20 even if the memory card 2 is removed from the data processing unit 4, it is not necessary to charge the auxiliary battery 20 each time the main battery 18 is replaced. In the present embodiment, even if the main battery 18 is removed from the memory card 2, the stored data in the s-RAM 14 is retained for nearly 10 minutes by the auxiliary battery 20.
(iii) By providing a new main battery 18 on the memory card 2, a voltage is supplied again from the main battery 18 to the S-RAM 14.
(iv) The memory card 2 whose main battery 18 is replaced with a new one is installed in the data processing unit 4.

As described above, even in the course of replacing the main battery 18, the stored data in the S-RAM 14 is retained and the output voltage of the external power supply 8 is not applied to the auxiliary battery 20.

Furthermore, the circuit configuration is simple. As compared with a conventional backup circuit, the number of component parts is not increased much. Because in a conventional backup circuit, a lithium battery or the like which cannot (must not) be charged as the main battery cannot is generally used, a diode never fails to be added in a circuit using such a main battery, regardless of whether the auxiliary battery 20 is present or not. Therefore, the number of component parts does not increase in the conventional backup circuit as a result from adding a second diode 22, as in the present invention.

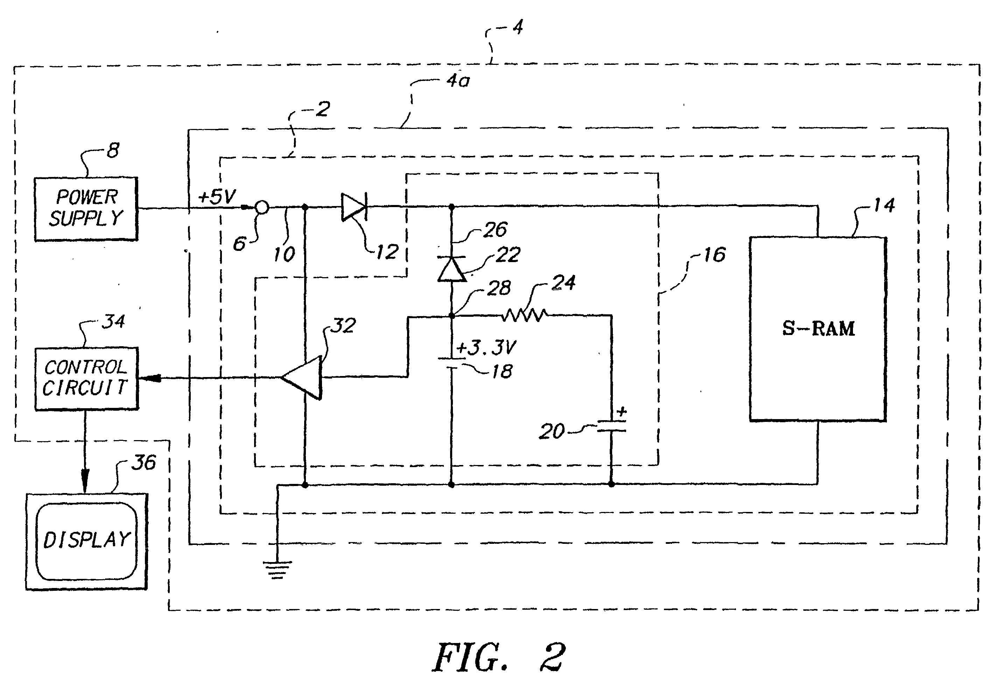

FIG. 2 shows a second embodiment of the present invention. The second embodiment differs from the first embodiment in that the former is provided with means for letting the operator know a drop in the output voltage of the main battery 18 of the memory card 2.

In FIG. 2, the backup circuit 16 of the memory card 2 contains a comparator 32 differently from the first embodiment. The comparator 32 in the present embodiment is a comparator 32 containing a reference voltage generating circuit. The comparator 32 has an input terminal, to which the output voltage (normally 3V) of the main battery 18 is supplied as an input voltage. The reference voltage generating circuit built in the comparator 32 generates a reference voltage (normally 2.3 V) to be compared with the output voltage of the main battery 18. The comparator 32 outputs an alarm signal (digital signal) when the input voltage drops below the reference voltage. The alarm signal is inputted to a control circuit 34 of the data processing unit 4. The control circuit 34, on the basis of the alarm signal, displays a message that the main battery 18 is consumed, on a display 36 provided for the data processing unit 4.

Alternatively, the comparator 32 may be provided for the data processing unit 4. In this case, the comparator 32 may be of a type which directly senses the output voltage (analog signal) of the main battery 18. Furthermore, in this case, the output voltage of the external power supply 8 is not necessarily used as a reference voltage.

The present invention is not limited to the above embodiments. It will be obvious to those skilled in the art that the invention may be practiced or embodied in still other ways without departing from the spirit or essential character thereof. For instance, by using the output of the comparator 32 to drive acoustic and/or optical and/or visual alarm means such as a buzzer or a lamp, in addition to the display 36, it is possible to let the operator know a drop in the output voltage of the main battery 18.

The data processing medium 2 to which the present invention is to be applied contains various types of IC (integrated circuit) cards on which semiconductor storage elements requiring constant voltage supply for retaining data are provided, in addition to a memory card.

As has been explained, according to the data processing medium of the invention and its backup circuit and the data processing system of the invention, because the second backup means is charged by the first backup means, it is not necessary to charge the second backup means before replacement of the first backup means, thereby reducing the number of charges and discharges of the second backup means. Because a charging current does not flow from the external power supply to the second backup means, the second backup means may be one with low withstand voltage characteristics and consequently be an inexpensive one. Furthermore, the configuration of the backup circuit is simple.

## Claims

1. A backup circuit for backing up stored data in a data processing medium (2) comprising a semiconductor element (14) which can at least store data and a voltage input terminal (6) which can be connected to an external power supply (8) and a voltage supply line (10) connected to the input terminal (6) to supply a voltage from the external power supply (8) so as to operate the semiconductor element, said backup circuit comprising:
first and second backup means (18, 20) each of which serves to back up the stored data in the semiconductor element during the time when the external power supply is disconnected from the voltage input terminal, each backup means (18, 20) having a positive and a negative electrode
wherein: charging prevention means (22) is connected to the positive electrodes of both the first and second backup means (18, 20) and to the voltage supply line (10) so as to prevent charging of both the backup means (18, 20) when the voltage input terminal (6) is connected to the external power supply (8);
the first backup means (18) is re-chargeable and removable and the positive electrodes of the first and second backup means (18, 20) are directly interconnected electrically so the second backup means (20) is charged only by the first backup means (18);
the positive electrode of the second backup means (20) is electrically connected to the semiconductor element (14) via the charging preventing means (22) and the voltage supply line so as to energize the semiconductor element (14) and back up the stored data in the semiconductor element (14) during the time when the external power supply is disconnected from the voltage input terminal (6) and the first backup means (18) is removed from the data processing medium, and
the positive electrode of the first backup means (18) is electrically connected to the semiconductor element (14) via the charging preventing means (22) and the voltage supply line (10) to energize the semiconductor element (14) and back up the stored data in the semiconductor element (14) when the external power supply is disconnected from the voltage input terminal (6).

2. A backup circuit according to claim 1, wherein the positive electrodes of said first and second backup means (18, 20) are connected directly in parallel.

3. A backup circuit according to claim I, wherein the positive electrodes of said first backup means and second backup means (18, 20) are connected in parallel via a resistance (24).

4. A backup circuit according to any one of claims 1 to 3, wherein said second backup means (20) is a capacitor.

5. A backup circuit according to any one of claims 1 to 3, wherein said second backup means (20) is a rechargeable battery also removable from the data processing medium.

6. A backup circuit according to any one of claims 1 to 5, wherein said charging prevention means is a diode (22) arranged in a forward conductive direction running from the positive electrode of the first backup means toward said supply line (10).

7. A backup circuit according to any one of claims 1 to 6 and further comprising a diode (12) connected between the supply line (10) and the terminal (6) to prevent the flow of electrical current from the first and second backup means (18, 20) to the external power supply (8) when the power supply (8) is connected to the terminal (6).

8. A data processing medium (2) incorporating a semiconductor element (14) which can at least store data, a voltage input terminal (6) connectable to an external power supply (8), a voltage supply line (10) connected to the terminal (6) to supply a voltage from the external supply (8) to operate the semiconductor element (14) and a backup circuit according to any one of the preceding claims.

9. A data processing medium according to claim 8 and in the form of an integrated circuit card.

10. A data processing medium according to claim 8 and in the form of a memory card.

11. A data processing medium according to claim 8, 9 or 10, wherein said semiconductor element (14) is a static random access memory.

12. A data processing system comprising a data processing medium according to any one of claims 8 to 11 and a data processing unit (4) to which the data processing medium (2) is to be connected, said data processing unit comprising said power supply (8) for supplying voltage to the terminal (6) and transmission/reception means for transmitting and/or receiving data to and from said semiconductor element of said data processing medium.

13. A data processing system according to claim 12 and further comprising connection means (4a) for connecting said data processing medium (2) and said data processing unit (4) so that data may be transmitted and/or received between said semiconductor element of said data processing medium and said transmission/reception means of said data processing unit.

14. A data processing system according to claim 13, wherein said connection means is a connector which is installed in said data processing unit (4) and into which said data processing medium (2) can be installed.

15. A data processing system according to any one of claims 12 to 14, further comprising means for letting an operator know the consumption of the first backup means (18) of said data processing medium.

16. A data processing system according to any one of claims 12 to 14 and further comprising a comparator (32) with an input terminal connected to the positive electrode of the first backup means (18), the comparator (32) serving to activate an alarm signal when the voltage at the input terminal thereof falls below a reference voltage.

## Patentansprüche

1. Sicherungsschaltung zur Sicherung gespeicherter Daten in einem Datenverarbeitungsmedium (2), umfassend ein Halbleiterelement (14), das wenigstens Daten speichern kann, und eine Spannungseingangsklemme (6), die an eine äußere Stromversorgung (8) angeschlossen werden kann, und eine mit der Eingangsklemme (6) verbundene Spannungsversorgungsleitung (10) zur Einspeisung einer Spannung von der äußeren Stromversorgung (8), um das Halbleiterelement zu betreiben, wobei die Sicherungsschaltung umfaßt:
erste und zweite Sicherungsmittel (18, 20), die jeweils dazu dienen, während der Zeit, in der die äußere Stromversorgung von der Spannungseingangsklemme getrennt ist, die gespeicherten Daten in dem Halbleiterelement zu sichern, wobei jedes Sicherungsmittel (18, 20) eine positive und eine negative Elektrode aufweist,
wobei: ein die Aufladung verhinderndes Mittel (22) mit den positiven Elektroden sowohl des ersten als auch des zweiten Sicherungsmittels (18, 20) und mit der Spannungsversorgungsleitung (10) verbunden ist, um ein Aufladen beider Sicherungsmittel (18, 20) zu verhindern, wenn die Spannungseingangsklemme (6) mit der äußeren Stromversorgung (8) verbunden ist;
das erste Sicherungsmittel (18) wiederaufladbar und ausbaubar ist und die positiven Elektroden des ersten und des zweiten Sicherungsmittels (18, 20) direkt elektrisch miteinander verbunden sind, so daß das zweite Sicherungsmittel (20) nur von dem ersten Sicherungsmittel (18) aufgeladen wird;
die positive Elektrode des zweiten Sicherungsmittels (20) über das die Aufladung verhindernde Mittel (22) und die Spannungsversorgungsleitung elektrisch mit dem Halbleiterelement (14) verbunden ist, um das Halbleiterelement (14) zu speisen und die gespeicherten Daten während der Zeit, in der die äußere Stromversorgung von der Spannungseingangsklemme (6) getrennt ist und das erste Sicherungsmittel (18) aus dem Datenverarbeitungsmedium ausgebaut ist, in dem Halbleiterelement (14) zu sichern, und
die positive Elektrode des ersten Sicherungsmittels (18) über das die Aufladung verhindemde Mittel (22) und die Spannungsversorgungsleitung (10) elektrisch mit dem Halbleiterelement (14) verbunden ist, um das Halbleiterelement (14) zu speisen und die gespeicherten Daten in dem Halbleiterelement (14) zu sichern, wenn die äußere Stromversorgung von der Spannungseingangsklemme (6) getrennt ist.

2. Sicherungsschaltung nach Anspruch 1, wobei die positiven Elektroden des ersten und des zweiten Sicherungsmittels (18, 20) direkt parallel geschaltet sind.

3. Sicherungsschaltung nach Anspruch 1, wobei die positiven Elektroden des ersten Sicherungsmittels und des zweiten Sicherungsmittels (18, 20) über einen Widerstand (24) parallel geschaltet sind.

4. Sicherungsschaltung nach einem der Ansprüche 1 bis 3, wobei das zweite Sicherungsmittel (20) ein Kondensator ist.

5. Sicherungsschaltung nach einem der Ansprüche 1 bis 3, wobei das zweite Sicherungsmittel (20) eine wiederaufladbare Batterie und ebenfalls aus dem Datenverarbeitungsmittel ausbaubar ist.

6. Sicherungsschaltung nach einem der Ansprüche 1 bis 5, wobei das die Aufladung verhindernde Mittel eine Diode (22) ist, die in einer von der positiven Elektrode des ersten Sicherungsmittels zur Versorgungsleitung (10) verlaufenden Durchlaßrichtung angeordnet ist.

7. Sicherungsschaltung nach einem der Ansprüche 1 bis 6, die außerdem eine Diode (12) umfaßt, welche zwischen der Versorgungsleitung (10) und der Klemme (6) angeschlossen ist, um das Fließen eines elektrischen Stromes von dem ersten und dem zweiten Sicherungsmittel (18, 20) zur äußeren Stromversorgung (8) zu verhindern, wenn die Stromversorgung (8) an der Klemme (6) angeschlossen ist.

8. Datenverarbeitungsmedium (2), das ein Halbleiterelement (14), das wenigstens Daten speichern kann, eine Spannungseingangsklemme (6), die an eine äußere Stromversorgung (8) angeschlossen werden kann, eine mit der Klemme (6) verbundene Spannungsversorgungsleitung (10) zur Einspeisung einer Spannung von der äußeren Stromversorgung (8), um das Halbleiterelement (14) zu betreiben, und eine Sicherungsschaltung nach einem der vorhergehenden Ansprüche umfaßt.

9. Datenverarbeitungsmedium nach Anspruch 8 und in Form einer Leiterplatte.

10. Datenverarbeitungsmedium nach Anspruch 8 und in Form einer Speicherkarte.

11. Datenverarbeitungsmedium nach Anspruch 8, 9 oder 10, wobei das Halbleiterelement (14) ein statischer Schreib-Lese-Speicher mit wahlfreiem Zugriff ist.

12. Datenverarbeitungssystem, umfassend ein Datenverarbeitungsmedium nach einem der Ansprüche 8 bis 11 und eine Datenverarbeitungseinheit (4), mit der das Datenverarbeitungsmedium (2) zu verbinden ist, wobei die Datenverarbeitungseinheit die Stromversorgung (8) zur Zuführung von Spannung zur Klemme (6) und Übertragungs/Empfangsmittel zur Übertragung und/oder zum Empfang von Daten zu und von dem Halbleiterelement des Datenverarbeitungsmediums umfaßt.

13. Datenverarbeitungssystem nach Anspruch 12, das außerdem ein Verbindungsmittel (4a) zur Verbindung des Datenverarbeitungsmediums (2) und der Datenverarbeitungseinheit (4) umfaßt, so daß Daten zwischen dem Halbleiterelement des Datenverarbeitungsmediums und den Übertragungs/Empfangsmitteln der Datenverarbeitungseinheit übertragen und/oder empfangen werden können.

14. Datenverarbeitungssystem nach Anspruch 13, wobei das Verbindungsmittel ein Steckverbinder ist, der in der Datenverarbeitungseinheit (4) montiert ist und in den das Datenverarbeitungsmedium (2) eingesteckt werden kann.

15. Datenverarbeitungssystem nach einem der Ansprüche 12 bis 14, das außerdem Mittel umfaßt, um eine Bedienungsperson den Verbrauch des ersten Sicherungsmittels (18) des Datenverarbeitungsmediums wissen zu lassen.

16. Datenverarbeitungssystem nach einem der Ansprüche 12 bis 14, das außerdem einen Vergleicher (32) mit einer Eingangsklemme, die an die positive Elektrode des ersten Sicherungsmittels (18) angeschlossen ist, umfaßt, wobei der Vergleicher (32) dazu dient, ein Alarmsignal zu aktivieren, wenn die Spannung an seiner Eingangsklemme unter eine Bezugsspannung fällt.

## Revendications

1. Circuit de sauvegarde pour sauvegarder des données stockées dans un moyen de traitement de données (2), comprenant un élément à semi-conducteur (14) qui peut , au moins, stocker des données et une borne d'entrée de tension (6) qui peut être connectée à une alimentation électrique externe (8) et une ligne d'alimentation en tension (10) connectée à la borne d'entrée (6) pour fournir une tension à partir de l'alimentation électrique externe (8) de façon à faire fonctionner l'élément à semi-conducteur, ledit circuit de sauvegarde comprenant :
des premier et second moyens de sauvegarde (18, 20) dont chacun sert à sauvegarder les données stockées dans l'élément à semi-conducteur pendant le temps où l'alimentation électrique externe est déconnectée de la borne d'entrée de tension, chaque moyen de sauvegarde (18, 20) comportant une électrode positive et une électrode négative.
dans lequel : des moyens de prévention de charge (22) sont connectés aux électrodes positives à la fois des premier et second moyens de sauvegarde (18, 20) et à la ligne d'alimentation en tension (10) de façon à empêcher de charger les deux moyens de sauvegarde (18, 20) lorsque la borne d'entrée de tension (6) est connectée à l'alimentation électrique externe (8) ;
le premier moyen de sauvegarde (18) est rechargeable et amovible et les électrodes positives des premier et second moyens de sauvegarde (18, 20) sont directement interconnectés électriquement de sorte que le second moyen de sauvegarde (20) est chargé seulement par le premier moyen de sauvegarde (18) ;
l'électrode positive du second moyen de sauvegarde (20) est connectée électriquement à l'élément à semi-conducteur (14) par l'intermédiaire des moyens de prévention de charge (22) et de la ligne d'alimentation en tension de façon à fournir de l'énergie à l'élément semi-conducteur (14) et à sauvegarder les données stockées dans l'élément à semi-conducteur (14) pendant le temps où l'alimentation électrique externe est déconnectée de la borne d'entrée de tension (6) et où le premier moyen de sauvegarde (18) est écarté du moyen de traitement de données, et
l'électrode positive du premier moyen de sauvegarde (18) est connectée électriquement à l'élément à semi-conducteur (14) par l'intermédiaire des moyens de prévention de charge (22) et de la ligne d'alimentation en tension (10) pour fournir de l'énergie à l'élément à semi-conducteur (14) et sauvegarder les données stockées dans l'élément à semi-conducteur (14) lorsque l'alimentation électrique externe est déconnectée de la borne d'entrée de tension (6).

2. Circuit de sauvegarde selon la revendication 1, dans lequel les électrodes positives desdits premier et second moyens de sauvegarde (18, 20) sont connectées directement en parallèle.

3. Circuit de sauvegarde selon la revendication 1, dans lequel les électrodes positives dudit premier moyen de sauvegarde et dudit second moyen de sauvegarde (18, 20) sont connectées en parallèle par l'intermédiaire d'une résistance (24).

4. Circuit de sauvegarde selon l'une quelconque des revendications 1 à 3, dans lequel ledit second moyen de sauvegarde (20) est un condensateur.

5. Circuit de sauvegarde selon l'une quelconque des revendications 1 à 3, dans lequel ledit second moyen de sauvegarde (20) est une batterie rechargeable également séparable du moyen de traitement de données.

6. Circuit de sauvegarde selon l'une quelconque des revendications 1 à 5, dans lequel ledit moyen de prévention de charge est une diode (22) agencée dans un sens conducteur faisant passer le courant de l'électrode positive du premier moyen de sauvegarde vers ladite ligne d'alimentation (10).

7. Circuit de sauvegarde selon l'une quelconque des revendications 1 à 6 et comprenant, de plus, une diode (12) connectée entre la ligne d'alimentation (10) et la borne (6) pour empêcher le flux de courant électrique allant des premier et second moyens de sauvegarde (18, 20) vers l'alimentation électrique externe (8) lorsque l'alimentation électrique (8) est connectée à la borne (6).

8. Moyen de traitement de données (2) incorporant un élément à semi-conducteur (14) qui peut au moins stocker des données, une borne d'entrée de tension (6) pouvant être connectée à une alimentation électrique externe (8), une ligne d'alimentation en tension (10) connectée à la borne (6) pour fournir une tension à partir de l'alimentation externe (8) afin de faire fonctionner l'élément à semi-conducteur (14) et un circuit de sauvegarde selon l'une quelconque des revendications précédentes.

9. Moyen de traitement de données selon la revendication 8 et sous la forme d'une carte de circuits intégrés.

10. Moyen de traitement de données selon la revendication 8 et sous la forme d'une carte à mémoire.

11. Moyen de traitement de données selon la revendication 8, 9 ou 10, dans lequel ledit élément à semi-conducteur (14) est une mémoire vive statique.

12. Système de traitement de données comprenant un moyen de traitement de données selon l'une quelconque des revendications 8 à 11 et une unité de traitement de données (4) à laquelle le moyen de traitement de données (2) doit être connecté, ladite unité de traitement de données comprenant ladite alimentation électrique (8) pour fournir une tension à la borne (6) et des moyens d'émission/réception pour émettre et/ou recevoir des données vers ledit élément à semi-conducteur et à partir de cet élément dudit moyen de traitement de données.

13. Système de traitement de données selon la revendication 12 et comprenant, de plus, des moyens de connexion (4a) pour connecter ledit moyen de traitement de données (2) et ladite unité de traitement de données (4) de façon que les données puissent être émises et/ou reçues entre ledit élément à semi-conducteur dudit moyen de traitement de données et lesdits moyens d'émission/réception de ladite unité de traitement de données.

14. Système de traitement de données selon la revendication 13, dans lequel lesdits moyens de connexion sont un connecteur qui est installé dans ladite unité de traitement de données (4) et dans lequel ledit moyen de traitement de données (2) peut être installé.

15. Système de traitement de données selon l'une quelconque des revendications 12 à 14, comprenant de plus, des moyens pour permettre à un opérateur de connaitre la consommation du premier moyen de sauvegarde (18) dudit moyen de traitement de données.

16. Système de traitement de données selon l'une quelconque des revendications 12 à 14, et comprenant, de plus, un comparateur (32) ayant une borne d'entrée connectée à l'électrode positive du premier moyen de sauvegarde (18), le comparateur (32) servant à activer un signal d'alarme lorsque la tension au niveau de sa borne d'entrée tombe au-dessous d'une tension de référence.
